# EUROPEAN PATENT APPLICATION

(11) **EP 4 439 631 A1**
(43) Date of publication of application: **02.10.2024**
(21) Application number: 24164191.9
(22) Date of filing: 18.03.2024
(51) Int. Cl.: H01L 21/20, H01L 21/033

(54) **METHODS OF FORMING A SEMICONDUCTOR STRUCTURE**

(30) Priority: 21.03.2023 US 202363453750 P
(71) Applicant: ASM IP Holding B.V., 1322 AP Almere (NL)
(72) Inventor: CHOUDHURY, Devika, 1322 AP Almere (NL); WINKLER, Jereld Lee, 1322 AP Almere (NL); MULLAPUDI, Kamesh, 1322 AP Almere (NL); BALSEANU, Mihaela, 1322 AP Almere (NL); SCHMOTZER, Michael, 1322 AP Almere (NL)
(74) Representative: V.O.

(57) **Abstract**

Methods for forming a semiconductor structure are disclosed. The methods include forming a bilayer hardmask by depositing a first hardmask layer and a second hardmask layer over a substrate including a first region and a second region. Exemplary structures formed can include CMOS device structures.

## Description

The present disclosure generally relates to methods for forming semiconductor structures, and particularly to methods for forming semiconductor structures including a bilayer hardmask. The present disclosure also generally relates to structures including a bilayer hardmask.

### BACKGROUND OF THE DISCLOSURE

The scaling of semiconductor devices, such as, for example, complementary metal-oxide-semiconductor (CMOS) devices, has led to significant improvements in speed and density of integrated circuits. However, conventional device scaling techniques face significant challenges for future technology nodes.

For example, one challenge has been finding suitable hardmask materials utilized in the fabrication of the PMOS regions and the NMOS regions of CMOS device structures. Accordingly, novel hardmask materials and hardmask structures are desirable for improved CMOS fabrication methods.

Any discussion, including discussion of problems and solutions, set forth in this section has been included in this disclosure solely for the purpose of providing a context for the present disclosure. Such discussion should not be taken as an admission that any or all of the information was known at the time the invention was made or otherwise constitutes prior art.

### SUMMARY OF THE DISCLOSURE

This summary may introduce a selection of concepts in a simplified form, which may be described in further detail below. This summary is not intended to necessarily identify key features or essential features of the claimed subject matter, nor is it intended to be used to limit the scope of the claimed subject matter.

Various embodiments of the present disclosure relate to methods for forming semiconductor structures and particular semiconductor structures including hardmask layers and hardmask structures. For example, such hardmask layers and structures can be utilized in the fabrication of CMOS device structures, such as, for example, in such fabrication processes as etching process employed in the fabrication of CMOS device structure, for example.

In accordance with exemplary embodiments of the current disclosure, methods of forming a semiconductor structure are disclosed. The methods of the current disclosure include, seating a substrate comprising a first region and a second region into a reaction chamber, and forming a bilayer hardmask on the substrate. In some embodiments, forming the bilayer hardmask comprises, performing one or more deposition cycles of a first cyclical deposition process to deposit a first hardmask layer comprising a first metal oxide on the substrate and performing one or more deposition cycles of a second cyclical deposition process to deposit a second hard mask layer comprising a second metal oxide on the first metal oxide hardmask layer.

In some embodiments, a first unit deposition cycle of the first cyclical deposition process comprises, providing a first metal precursor to the reaction chamber, and providing a first oxidizer to the reaction chamber.

In some embodiments, the first hardmask layer comprises aluminum oxide.

In some embodiments, a second unit deposition cycle of the second cyclical deposition process comprises, providing a second metal precursor to the reaction chamber, and providing a second oxidizer to the reaction chamber.

In some embodiments, the second hardmask layer is selected from the group consisting of hafnium oxide, yttrium oxide, and zirconium oxide.

In some embodiments, the methods of present disclosure further include, selectively removing the bilayer hardmask from over the first region of the substrate to expose a surface of the first region of the substrate.

In some embodiments, selectively removing the bilayer hardmask from the first region of the substrate further includes, forming a patterned resist layer over the second region of the substrate and contacting an exposed region of the bilayer hardmask with a wet etchant.

In some embodiments, the wet etchant is selected from the group consisting of, hydrofluoric acid, sulfuric acid, and phosphoric acid.

In some embodiments, the methods of the present disclosure further include, performing a cleaning process on the exposed surface of the first region of substrate thereby forming a cleaned first region surface.

In some embodiments, the cleaning process comprises, contacting the exposed surface of the first region of the substrate with a plasma generated from a gas mixture comprising a fluorine containing gas and ammonia.

In some embodiments, the cleaning process removes the second hardmask layer from over the second region of the substrate.

In some embodiments, the methods of the present disclosure can further include, forming a semiconductor layer on the cleaned first region surface

In some embodiments, forming the semiconductor layer comprises, depositing a semiconductor layer directly on the cleaned first region surface by an epitaxial deposition process.

In some embodiments, the methods of the present disclosure can further include, removing any remaining portions of the bilayer hardmask from over the second region of the substrate.

The embodiments of the present disclosure can also include further methods for forming a semiconductor structure. In some embodiments, the methods of the present disclosure include, seating a substrate comprising a NMOS region and a PMOS region into a reaction chamber and depositing a bilayer hardmask over the NMOS region and over the PMOS region. In some embodiments, depositing the bilayer hardmask can include, depositing a first hardmask layer over both the NMOS region and the PMOS region and depositing a second hardmask layer over the first hardmask layer. The methods of the present disclosure can further include, selectively removing the bilayer hardmask over the NMOS region to expose a surface of the NMOS region, performing a cleaning process on the exposed surface of the NMOS region thereby forming a clean NMOS surface, depositing a semiconductor layer on the clean NMOS surface, and removing a remaining portion of the bilayer hardmask disposed over the PMOS region.

In some embodiments, the bilayer hardmask is deposited by a cyclical deposition process.

In some embodiments, the semiconductor layer is deposited by an epitaxial deposition process.

In some embodiments, selectively removing the bilayer hardmask over the NMOS region can further include, forming a patterned resist layer over the PMOS region and contacting an exposed region of the bilayer hardmask with a wet etchant selected from the group consisting of hydrofluoric acid, sulfuric acid, and phosphoric acid.

In some embodiments, the cleaning process removes the second hardmask layer over the PMOS region whilst maintaining at least a portion of the first hardmask layer over the PMOS region.

The embodiments of the present disclosure also disclose, semiconductor structure formed according to methods disclosed herein.

These and other embodiments will become readily apparent to those skilled in the art from the following detailed description of certain embodiments having reference to the attached figures. The invention is not being limited to any particular embodiments disclosed.

### BRIEF DESCRIPTION OF THE DRAWING FIGURES

A more complete understanding of the embodiments of the present disclosure may be derived by referring to the detailed description and claims when considered in connection with the following illustrative figures.
FIG. 1 illustrates an exemplary method in accordance with the embodiments of the disclosure;
FIG. 2 illustrates a further exemplary method in accordance with the embodiments of the disclosure; and
FIG. 3 to FIG. 5 illustrate exemplary structures in accordance with embodiments of the disclosure.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

The description of exemplary embodiments of methods, structures, devices, and apparatus provided below is merely exemplary and is intended for purposes of illustration only; the following description is not intended to limit the scope of the disclosure or the claims. Moreover, recitation of multiple embodiments having stated features is not intended to exclude other embodiments having additional features or other embodiments incorporating different combinations of the stated features. For example, various embodiments are set forth as exemplary embodiments and may be recited in the dependent claims. Unless otherwise noted, the exemplary embodiments or components thereof may be combined or may be applied separate from each other.

As set forth in more detail below, various embodiments of the disclosure provide methods for forming semiconductor structures suitable for a variety of applications. Exemplary methods can be used, for example, in the formation of complementary metal-oxide-semiconductor (CMOS) device structures. For example, the methods of the present disclosure can include bilayer hardmasks that can be used in the formation of logic devices, dynamic random-access memory (DRAM), three-dimensional NAND devices. However, unless noted otherwise, the invention is not necessarily limited to such examples.

In this disclosure, "gas" can include material that is a gas at normal temperature and pressure (NTP), a vaporized solid and/or a vaporized liquid, and can be constituted by a single gas or a mixture of gases, depending on the context. A gas other than the process gas, i.e., a gas introduced without passing through a gas distribution assembly, other gas distribution device, or the like, can be used for, e.g., sealing the reaction space, and can include a seal gas, such as a rare gas. In some cases, the term "precursor" can refer to a compound that participates in the chemical reaction that produces another compound, and particularly to a compound that constitutes a film matrix or a main skeleton of a film; the term "reactant" can be used interchangeably with the term precursor. The term "inert gas" can refer to a gas that does not take part in a chemical reaction and/or does not become a part of a film matrix to an appreciable extent. Exemplary inert gases include helium, argon, and any combination thereof. In some cases, an inert gas can include nitrogen and/or hydrogen.

As used herein, the term "substrate" can refer to any underlying material or materials that can be used to form, or upon which, a device, a circuit, or a film can be formed. A substrate can include a bulk material, such as silicon (e.g., single-crystal silicon), other Group IV materials, such as germanium, or other semiconductor materials, such as Group II-VI or Group III-V semiconductor materials, and can include one or more layers overlying or underlying the bulk material. Further, the substrate can include various features, such as recesses, protrusions, and the like formed within or on at least a portion of a layer of the substrate. By way of examples, a substrate can include bulk semiconductor material and an insulating or dielectric material layer overlying at least a portion of the bulk semiconductor material.

As used herein, the term "film" and/or "layer" can refer to any continuous or non-continuous structure and material, such as material deposited by the methods disclosed herein. For example, film and/or layer can include two-dimensional materials, three-dimensional materials, nanoparticles or even partial or full molecular layers or partial or full atomic layers or clusters of atoms and/or molecules. A film or layer may comprise material or a layer with pinholes, which may be at least partially continuous.

As used herein, a "structure" can be or include a substrate as described herein. Structures can include one or more layers overlying or within the substrate, such as one or more layers formed according to a method as described herein. Full devices or partial device portions can be included within or on structures.

The term "cyclic deposition process" or "cyclical deposition process" can refer to the sequential introduction of precursors (and/or reactants) into a reaction chamber to deposit a layer over a substrate and includes processing techniques such as atomic layer deposition (ALD), cyclical chemical vapor deposition (cyclical CVD), and hybrid cyclical deposition processes that include an ALD component and a cyclical CVD component.

The term "atomic layer deposition" can refer to a vapor deposition process in which deposition cycles, typically a plurality of consecutive deposition cycles, are conducted in a process chamber. The term atomic layer deposition, as used herein, is also meant to include processes designated by related terms, such as chemical vapor atomic layer deposition, atomic layer epitaxy (ALE), molecular beam epitaxy (MBE), gas source MBE, organometallic MBE, and chemical beam epitaxy, when performed with alternating pulses of precursor(s)/reactive gas(es), and purge (e.g., inert carrier) gas(es).

Generally, for ALD processes, during each deposition cycle, a precursor is introduced to a reaction chamber and is chemisorbed to a deposition surface (e.g., a substrate surface that can include a previously deposited material from a previous ALD cycle or other material) and forming about a monolayer or sub-monolayer of material that does not readily react with additional precursor (i.e., a self-limiting reaction). Thereafter, in some cases, a reactant (e.g., another precursor or reaction gas) may subsequently be introduced into the process chamber for use in converting the chemisorbed precursor to the desired material on the deposition surface. The reactant can be capable of further reaction with the precursor. Purging steps can be utilized during one or more deposition cycles, e.g., during each step of each cycle, to remove any excess precursor from the process chamber and/or remove any excess reactant and/or reaction byproducts from the reaction chamber.

Further, in this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, or the like. Further, in this disclosure, the terms "including," "constituted by" and "having" refer independently to "typically or broadly comprising," "comprising," "consisting essentially of," or "consisting of" in some embodiments. In this disclosure, any defined meanings do not necessarily exclude ordinary and customary meanings in some embodiments.

In the specification, it will be understood that the term "on" or "over" may be used to describe a relative location relationship. Another element, film or layer may be directly on the mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

The present disclosure may include methods for forming a semiconductor structure and particularly semiconductor structures including a bilayer hardmask. In more detail, the processes employed in the fabrication of CMOS device structures can require optimized hardmask materials to avoid the epitaxial deposition of semiconductor layers, such as, silicon germanium (SiGe) and phosphorus doped silicon (SiP), for example, in undesired locations of the device structure.

In some CMOS fabrication methods, a metal oxide hardmask, such as, an aluminum oxide (AlOₓ) hardmask, for example, may be employed as a metal oxide hardmask during etch processes. However, a single layer metal oxide hardmask, such as aluminum oxide, for example, may include pinholes formed during the CMOS fabrication process and such pinholes may cause problems in downstream CMOS fabrication processes. For example, pinholes in a single layer metal oxide hardmask may cause fabrication problems when employing the hardmask to prevent epitaxial deposition of semiconductor layer in particular regions of a substrate.

Therefore, the embodiments of the present disclosure may employ a bilayer hardmask comprising a first hardmask layer and a second hardmask layer. For example, the first hardmask layer can comprise a first metal oxide, such as, aluminum oxide, for example, which is disposed directly over the substrate, and a second hardmask layer, which can comprise a second metal oxide, such as, for example, hafnium oxide, yttrium oxide, or zirconium oxide, where the second hardmask layer has a reduced dry etch rate relative to the first hardmask layer.

Therefore, the embodiments of the present disclosure employ a bilayer hardmask, such as, for a first metal oxide (MOₓ₁) and second metal oxide (MOₓ₂) rather than a single metal oxide hardmask layer, particular during fabrication processes requiring the masking of regions to prevent undesired epitaxial deposition in unwanted regions of the substrate. In some embodiments, the bilayer hardmask composed of a first metal oxide and a second metal oxide can be in form of a laminated structure. In some embodiments, the bilayer hardmask composed of a first metal oxide and a second metal oxide can be in form of a mixed metal oxide structure.

In some embodiments, the upper hardmask layer(the second hardmask layer) can have a lower dry etch rate than the lower hardmask layer (the first hardmask layer) and the upper hardmask layer can be formed to a sufficiently low thickness that it can be removed by employing wet etch processes employed during the CMOS fabrication process. For example, the CMOS fabrication processes of the present disclosure may employ a first wet etch step (e.g., employing dilute hydrofluoric acid), which can remove the bilayer hardmask from a first region (e.g., an NMOS region) of the substrate whilst maintaining the bilayer hardmask to protecting a second region (e.g., a PMOS region) of the substrate.

In subsequent fabrication processes of the present disclosure step, the bilayer hardmask remaining over the second region of the substrate (e.g., the PMOS region) can be removed after epitaxial deposited of a desired semiconductor layer over the first region of the substrate (e.g., deposition over the NMOS region). The uppermost hardmask layer, having a lower etch rate, can be removed whilst still maintaining the underlying lower hardmask layer intact and thereby avoiding the formation of any pin-holes in the lower hardmask layer. As a result, the subsequent epitaxial deposition processes on the NMOS region, for example, maintains protection for the PMOS region. In some embodiments, the employment of the bilayer hardmask and the methods of forming such a bilayer hardmask may be repeated again to protect the NMOS region during epitaxial deposit of a semiconductor layer (e.g., a SiGe semiconductor layer) over the PMOS region.

Therefore, the present disclosure may include methods for forming a semiconductor structure. In some embodiments, the methods can comprise, seating a substrate comprising a first region and a second region into a reaction chamber and forming a bilayer hardmask on the substrate. In some embodiments, forming the bilayer hardmask layer can comprise, performing one or more deposition cycles of a first cyclical deposition process to deposit a first hardmask layer comprising a first metal oxide on the substrate, and performing one or more deposition cycles of a second cyclical deposition process to deposit a second hard mask layer comprising a second metal oxide on the first metal oxide hardmask layer.

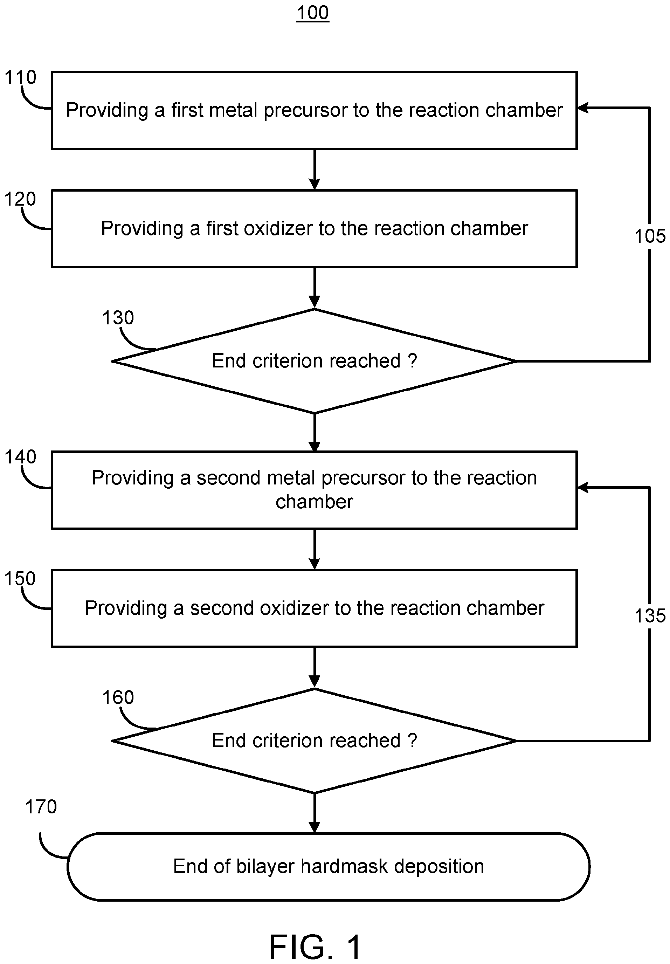

In more detail, FIG. 1 illustrates an exemplary process 100 that can be used to form a bilayer hardmask on a substrate comprising a first region and a second region. In brief, exemplary method 100 may include the steps of, providing a substrate within a reaction chamber and employing a first cyclical deposition process (cyclical process 105) for the deposition of a first hardmask layer comprising a first metal oxide over the substrate and subsequently a second cyclical deposition process (cyclical process 135) for the deposition of a second hardmask layer comprising a second metal oxide on the first metal hardmask layer. The first hardmask layer (i.e., the first metal oxide) is disposed proximate to the substrate and the second hardmask layer (i.e., the second metal oxide) is distal to the substrate and the combination of the first hardmask layer and the second hardmask layer makeup the bilayer hardmask.

In more detail, exemplary method 100 may include the step of providing a substrate within a reaction chamber. The reaction chamber employed for forming the bilayer hardmask during exemplary process 100 can be, or include, a reaction chamber of an atomic layer deposition reactor system configured to perform one or more cyclical deposition process. The reaction chamber can be a standalone reaction chamber or part of a cluster tool. The reaction chamber may be a batch processing tool. In some embodiments, a flow-type reactor may be utilized. In some embodiments, a showerhead-type reactor may be utilized. In some embodiments, a space divided reactor may be utilized. In some embodiments, a high-volume manufacturing-capable single wafer reactor may be utilized. In other embodiments, a batch reactor comprising multiple substrates may be utilized. For embodiments in which a batch reactor is used, the number of substrates may be in the range of 10 to 200, or 50 to 150, or even 100 to 130. The reactor can be configured as a thermal reactor-with no plasma excitation apparatus. Alternatively, the reactor can include direct and/or remote plasma apparatus.

The substrate disposed within the reaction chamber may be heated to a desired deposition temperature for a subsequent deposition. For example, the substrate may be heated to a substrate temperature of less than 800 °C, or less than 600 °C, or less than 400 °C, or even less than 200°C. In some embodiments of the disclosure, the substrate temperature may be greater than room temperature, between 200 °C and 800 °C , or between 200 °C and 600 °C, or between 200 °C and 400 °C. The temperature during the exemplary process 100 (FIG. 1) (i.e., the cyclical deposition process for forming the bilayer hardmask) can also be within these ranges.

In addition to controlling the temperature of the substrate, the pressure in the reaction chamber may also be regulated to enable deposition of the bilayer hardmask. For example, in some embodiments of the disclosure, the pressure within the reaction chamber may be less than 760 Torr, or between 0.1 Torr and 10 Torr, or between 0.5 Torr and 5 Torr, or between 1 Torr to 4 Torr.

Once the temperature of the substrate has been set to the desired deposition temperature and pressure in the reaction chamber has been regulated as desired, exemplary process 100 may continue to step 105 which comprises employing a first cyclical deposition process to deposit a first hardmask layer comprising a first metal oxide over a surface of a substrate and particular over a first region and over a second region of a substrate. For example, the embodiments of the present disclosure, may comprise, performing one or deposition cycles of a first cyclical deposition process to deposit a first metal oxide layer comprising aluminum oxide over a surface of a substrate, and particularly over a surface of a first region and over a surface of a second region.

In some embodiments, the first cyclical deposition process 105 may comprise providing a first metal precursor to the reaction chamber (process step 110) and providing a first oxidizer to the reaction chamber (process step 120). The first metal precursor and the first oxidizer can be separately and/or sequentially provided to the reaction chamber, with or without intervening reaction chamber purge sequences. The process step 110 and 120 (and any intervening purge sequences) may constitute a first unit deposition cycle and a first unit deposition cycle may be repeated one or more times to deposit a first hardmask layer (e.g., a first metal oxide) to a desired thickness over the substrate, and particularly over a first region and a second region.

In more detail, process step 110 comprises providing a first metal precursor to the reaction chamber. The first metal precursor can be pulsed to the reaction chamber. The term "pulse" can be understood to comprise feeding a precursor into the reaction chamber for a predetermined amount of time. Unless otherwise noted, the term "pulse" does not restrict the length or duration of the pulse and a pulse may be any length of time. The first metal precursor pulse may be supplied to the reaction chamber along with a carrier gas flow. In some embodiments, the first metal precursor may comprise a volatile metal species that is reactive with the surface(s) of the substrate. The first metal precursor pulse may self-saturate the substrate surfaces such that excess constituents of the gallium precursor pulse do not further react with the molecular layer formed by this process.

The first metal precursor pulse is preferably supplied as a vapor phase reactant. The first metal precursor gas may be considered "volatile" for the purposes of the present disclosure if the species exhibits sufficient vapor pressure under the process conditions to transport species to the substrate surface in sufficient concentration to saturate the exposed surfaces.

In accordance with some embodiments of the disclosure, the first hardmask layer can comprise an aluminum oxide and the step of providing the first metal precursor to the reaction chamber can comprise, providing an aluminum precursor to the reaction chamber. In some embodiments, the aluminum precursor can comprise one or more of, trimethyl aluminum (TMA), dimethylaluminumchloride, aluminum trichloride (AlCl3), dimethylaluminum isopropoxide (DMAI), tris(tertbutyl)aluminum (TTBA), tris(isopropoxide)aluminum (TIPA) or triethyl aluminum (TEA). In some embodiments, the aluminum precursor can comprise dimethylaluminum isopropoxide (DMAI).

The exemplary process 100 (FIG. 1) may continue with the process step 120 comprising, providing a first oxidizer to the reaction chamber. In some embodiments, the first oxidizer can comprise one or more of water (H₂O), hydrogen peroxide (H₂O₂), ozone (Os), or oxides of nitrogen, such as, for example, nitrogen monoxide (NO), nitrous oxide (N₂O), or nitrogen dioxide (NO₂). In some embodiments of the disclosure, the first oxidizer precursor may comprise an organic alcohol, such as, for example, isopropyl alcohol.

In some embodiments, the first cyclical deposition process 105 may be repeated one or more time until a desired end criterion is reach (process step 130) and the first cyclical deposition process may be terminated. In some embodiments, the end criterion of process step 130 can be reached based up a desired thickness of the first hardmask layer (e.g., the first metal oxide layer), or alternatively the end criterion of process step 130 may be reached upon performing a predetermined number of deposition cycle of the first cyclical deposition process 105. As a non-limiting example, the first cyclical deposition process 105 may be terminated after a desired thickness of aluminum oxide has been deposited over the substrate and particular over the first and second region of the substrate.

The exemplary process 100 (FIG. 1) may continue by performing one or more deposition cycles of a second cyclical deposition process (cyclical deposition process 135) to deposited a second hardmask layer comprising a second metal oxide, where the second hardmask layer (i.e., the second metal oxide) is deposited on the first hardmask layer (i.e., the first metal oxide). In some embodiments, the second hardmask layer is deposited directly on the first hardmask layer thereby forming the bilayer hardmask. The second cyclical deposition process 135 can be similar to that of that of the first cyclical deposition process 105 and therefore the following will describe the differences of the second cyclical deposition process 135.

In more detail, the second cyclical deposition process can be employed to deposit a second hardmask layer (e.g., a second metal oxide) on the first hardmask layer and in particular embodiments directly on the first hardmask layer thereby forming the bilayer hardmask.

In more detail, in some embodiments, the second cyclical deposition process 135 can comprise, providing a second metal precursor to the reaction chamber (process step 140), and providing a second oxidizer to the reaction chamber (process step 150). In some embodiment, the second hardmask layer is different in composition to the first hardmask layer. In some embodiments, the second hardmask layer comprises a different second metal oxide to the first metal oxide. In some embodiments, the second hardmask layer can be selected from the group consisting of hafnium oxide, yttrium oxide, and zirconium oxide.

For example, in embodiments wherein the second hardmask layer comprising hafnium oxide, providing a second metal precursor to the reaction chamber can comprise, providing a hafnium precursor to the reaction chamber. For example, the hafnium precursor can be selected from the group consisting of a hafnium halide precursor, and a hafnium metalorganic precursor. In some embodiments, a hafnium halide precursor comprises at least one of hafnium tetrachloride (HfCl₄), hafnium tetraiodide (HfI₄), or hafnium tetrabromide (HfBr₄). In some embodiments, a hafnium metalorganic precursor comprises at least one of tetrakis(ethylmethylamido)hafnium (Hf(NEtMe)₄), tetrakis(dimethylamido)hafnium (Hf(NMe₂)₄), tetrakis(diethylamido)hafnium (Hf(NEt₂)₄), (tris(dimethylamido)cyclopentadienylhafnium HfCp(NMe₂)₃, or bis(methylcyclopentadienyl)methoxymethyl hafnium (MeCp)₂Hf(CH)₃(OCH₃)

In some embodiment, the second hardmask layer can comprise a zirconium oxide layer. Therefore, in such embodiments, the second metal precursor can comprise a zirconium precursor, such as, Zr(NEtMe)₄, ZrCp₂(NMe₂)₂, Zr(O^{t}Bu)₄, for example.

In some embodiment, the second hardmask layer can comprise a yttrium oxide layer. Therefore, in such embodiments, the second metal precursor can comprise a yttrium precursor, such as, Y(CpBu)₃, Y(CpEt)₃, Y(CpMe)₃, for example.

The exemplary process 100 (FIG. 1) may continue with the process step 150 comprising, providing a second oxidizer to the reaction chamber. In some embodiments, the second oxidizer can comprise one or more of water (H₂O), hydrogen peroxide (H₂O₂), ozone (Os), or oxides of nitrogen, such as, for example, nitrogen monoxide (NO), nitrous oxide (N₂O), or nitrogen dioxide (NO₂). In some embodiments of the disclosure, the first oxidizer precursor may comprise an organic alcohol, such as, for example, isopropyl alcohol. In some embodiments, the first oxidizer and the second oxidizer may be the same, whereas in other embodiments, the first oxidizer and the second oxidizer may be different.

In some embodiments, the second cyclical deposition process 135 may be repeated one or more time until a desired end criterion is reach (process step 160) and the second cyclical deposition process may be terminated. In some embodiments, the end criterion of process step 160 can be reached based up a desired thickness of the second hardmask layer (e.g., the second metal oxide layer), or alternatively the end criterion of process step 160 may be reached upon completing a predetermined number of deposition cycle of the second cyclical deposition process 105. As a non-limiting example, the second cyclical deposition process 135 may be terminated after a desired thickness of hafnium oxide has been deposited over the first hardmask layer substrate. The exemplary process 100 can then terminate via the process step 170 upon completion of the formation of the bilayer hardmask.

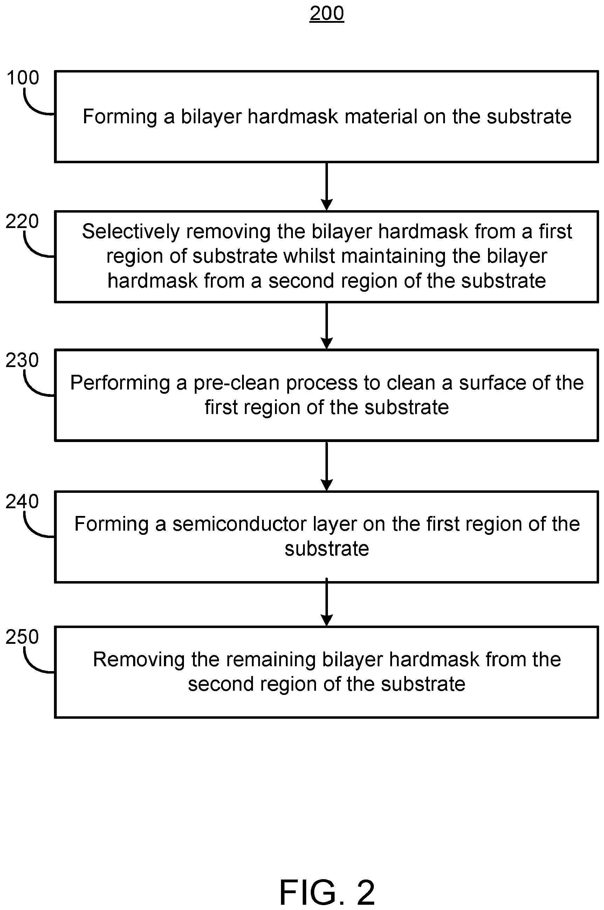

In some embodiments, the bilayer hardmasks of the present disclosure may be employed in the fabrication of a CMOS device structure. In more detail exemplary process 200 (FIG. 2) illustrates the employment of a bilayer hardmask of the present disclosure in the fabrication of CMOS device structures.

In more detail, the process 200 may commence with seating a substrate comprising a first region and a second region in a reaction chamber and forming a bilayer hardmask on the substrate, as previously described herein. The exemplary process 200 may then proceed via process step 220 which comprises, selectively removing the bilayer hardmask from over the first region of the substrate to expose a surface of the first region of the substrate. In some embodiments, selectively removing the bilayer hardmask from the first region of the substrate further comprises, forming a patterned resist layer over the second region of the substrate and contacting an exposed region of the bilayer hardmask with a wet etchant. In some embodiments, the wet etchant is selected from the group consisting of, hydrofluoric acid, sulfuric acid, and phosphoric acid, as well as diluted and hydrogen peroxide mixtures of the preceding wet etchants.

The exemplary process 200 may continue via a process step 230 which comprises, performing a cleaning process on the exposed surface of the first region of substrate thereby forming a cleaned first region surface. In some embodiments, the cleaning process comprises, contacting the exposed surface of the first region of the substrate with a plasma generated from a gas mixture comprising a fluorine containing gas (e.g., hydrofluoric acid, NF₃, NF₃*) and ammonia. In some embodiments, the cleaning process removes at least a portion of the second hardmask layer from over the second region of the substrate. In some embodiments, the cleaning process removes the second hardmask layer from over the second region of the substrate.

The exemplary process 200 may continue via a process step 240 which comprises, forming a semiconductor layer on the cleaned first region surface. In some embodiments, forming the semiconductor layer comprises, depositing a semiconductor layer directly on the cleaned first region surface by an epitaxial deposition process. In some embodiments, an epitaxial deposition process may be employed to deposit a SiGe layer, or a SiP layer on the cleaned first surface.

The exemplary process 200 may continue via a process step 240 which comprises, removing any remaining portions of the bilayer hardmask from over the second region of the substrate.

The bilayer hardmask of the present disclosure may be employed in other methods of fabricating CMOS device structures. In more detail, the processes of the present disclosure may comprise, seating a substrate comprising a NMOS region and a PMOS region into a reaction chamber, depositing a bilayer hardmask over the NMOS region and over the PMOS region. In some embodiments, depositing the bilayer hardmask comprises, depositing a first hardmask layer over both the NMOS region and the PMOS region, and depositing a second hardmask layer over the first hardmask layer. In some embodiments, the bilayer hardmask is deposited by a cyclical deposition process.

The processes of the present disclosure may further comprise, selectively removing the bilayer hardmask over the NMOS region to expose a surface of the NMOS region and performing a cleaning process on the exposed surface of the NMOS region thereby forming a clean NMOS surface. In some embodiments, selectively removing the bilayer hardmask over the NMOS region further comprises, forming a patterned resist layer over the PMOS region and contacting an exposed region of the bilayer hardmask with a wet etchant selected from the group consisting of hydrofluoric acid, sulfuric acid, and phosphoric acid.

The processes of the present disclosure may further comprise, depositing a semiconductor layer on the clean NMOS surface. In some embodiments, the semiconductor layer is deposited by an epitaxial deposition process.

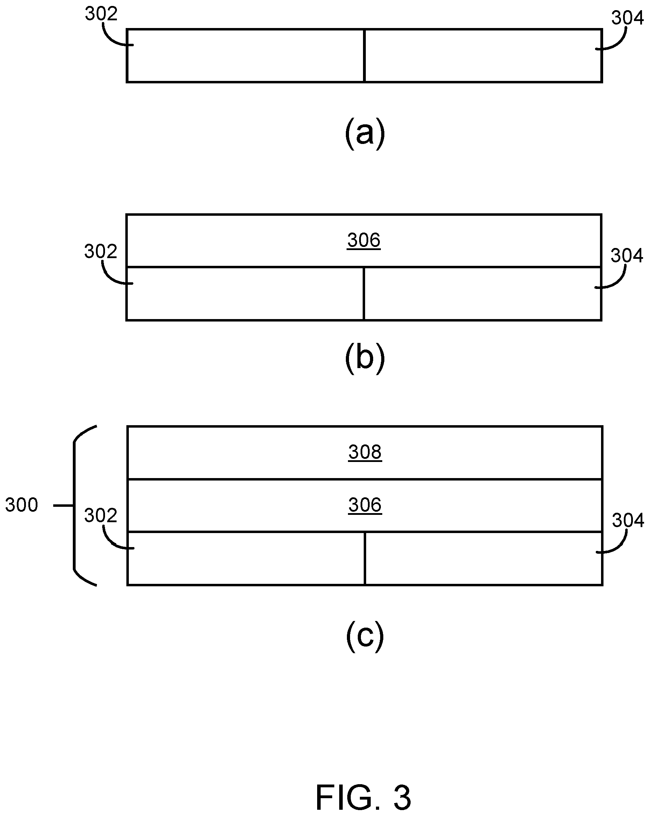

The embodiments of the present disclosure also include semiconductor structures formed by the methods disclosure herein. For example, FIG. 3(a) illustrates a substrate comprising a first region 304 (e.g., a NMOS region) and a second region 302 (e.g., a PMOS region). A first hardmask layer 306 (e.g., aluminum oxide) may be deposited over the surface of the first region and the second region, as illustrated in FIG. 3(b). A second hardmask layer 308 (e.g., hafnium oxide) may be deposited over the surface of the first hardmask layer 306 thereby forming the bilayer mask 300, as illustrated in FIG. 3(c).

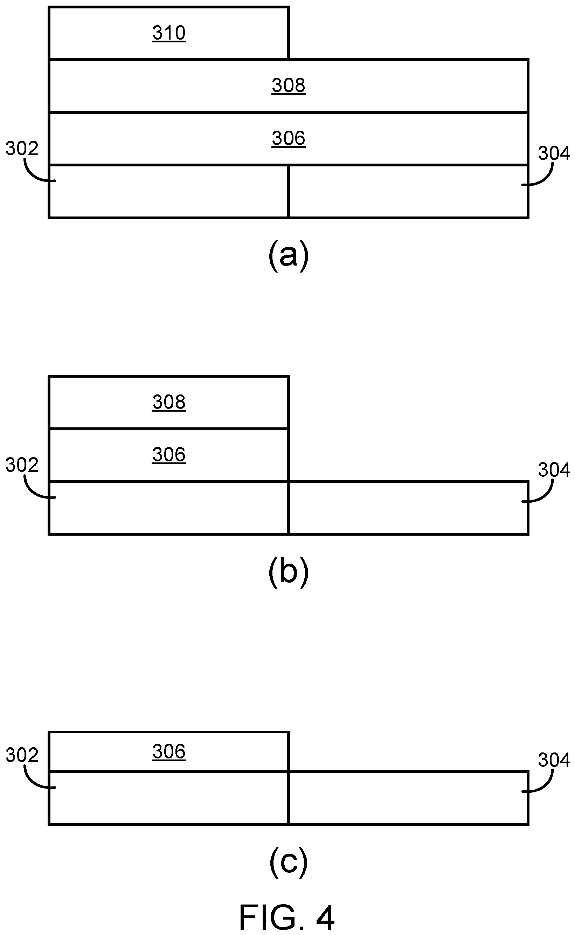

FIG. 4(a-c) illustrates further semiconductor structures that can be formed according to the embodiments of the present disclosure. For example, a patterned resist layer 310 may be formed and can be disposed over the second region 302 (e.g., the PMOS region), as illustrated in FIG. 4(a). A selective etch process can subsequently be performed to remove the bilayer hardmask from the region above the first region 304 (e.g., the NMOS region) and after removal of said layers the remaining patterned resist can be removed, as illustrated in FIG. 4(b). The structure illustrated in FIG. 4(b) may then be subjected to a cleaning process to provide a cleaned first region surface (e.g., a clean NMOS surface region) and during said cleaning the second hardmask layer 308 overlaying the second region 302 (e.g., the PMOS region) may be removed, as illustrated on FIG. 4(c). In some embodiments, the cleaning process may remove a portion of the second hardmask layer 308 overlaying the second region.

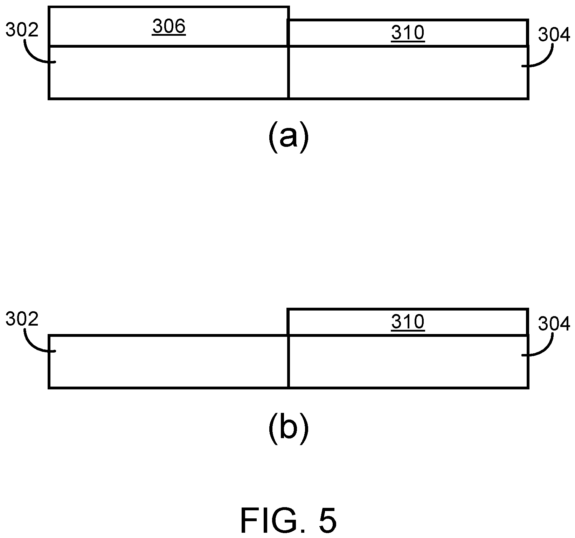

FIG. 5 (a,b) illustrates further structures that can be formed according to the embodiments of the present disclosure. For example, a semiconductor layer 310 can be deposited over the first region 304 (e.g., an NMOS region) by epitaxial deposition methods, as illustrated in FIG. 5(a). As illustrated in FIG. 5(a), the remaining portion of the bilayer hardmask prevents deposition of the semiconductor layer 310 over the second region 302 (e.g., the PMOS region). After deposition of the semiconductor layer 310, the remaining bilayer hardmask remaining over the second region 302 may be removed, e.g., by etching methods, as illustrated in FIG. 5(b).

The example embodiments of the disclosure described above do not limit the scope of the invention, since these embodiments are merely examples of the embodiments of the invention, which is defined by the appended claims and their legal equivalents. Any equivalent embodiments are intended to be within the scope of this invention. Indeed, various modifications of the disclosure, in addition to those shown and described herein, such as alternative useful combinations of the elements described, may become apparent to those skilled in the art from the description. Such modifications and embodiments are also intended to fall within the scope of the appended claims.

## Claims

1. A method of forming a semiconductor structure, the method comprising:
seating a substrate comprising a first region and a second region into a reaction chamber; and
forming a bilayer hardmask on the substrate, wherein forming the bilayer hardmask comprises:
performing one or more deposition cycles of a first cyclical deposition process to deposit a first hardmask layer comprising a first metal oxide on the substrate; and
performing one or more deposition cycles of a second cyclical deposition process to deposit a second hardmask layer comprising a second metal oxide on the first hardmask layer.

2. The method claim 1, wherein a first unit deposition cycle of the first cyclical deposition process comprises;
providing a first metal precursor to the reaction chamber; and
providing a first oxidizer to the reaction chamber.

3. The method of claim 2, wherein the first hardmask layer comprises aluminum oxide.

4. The method claim 3, wherein a second unit deposition cycle of the second cyclical deposition process comprises;
providing a second metal precursor to the reaction chamber; and
providing a second oxidizer to the reaction chamber.

5. The method of claim 4, wherein the second hardmask layer comprises aluminum oxide and a second different metal oxide.

6. The method of claim 4, wherein the second hardmask layer is selected from the group consisting of hafnium oxide, zirconium oxide, and yttrium oxide.

7. The method of any one of claims 1-6, further comprising, selectively removing the bilayer hardmask from over the first region of the substrate to expose a surface of the first region of the substrate.

8. The method of claim 7, wherein selectively removing the bilayer hardmask from the first region of the substrate further comprises, forming a patterned resist layer over the second region of the substrate and contacting an exposed region of the bilayer hardmask with a wet etchant.

9. The method of claim 8, wherein the wet etchant is selected from the group consisting of, hydrofluoric acid, sulfuric acid, and phosphoric acid.

10. The method of claim 7 further comprising, performing a cleaning process on the exposed surface of the first region of substrate thereby forming a cleaned first region surface.

11. The method of claim 10, wherein the cleaning process comprises, contacting the exposed surface of the first region with a plasma generated from a gas mixture comprising a fluorine containing gas and ammonia.

12. The method of claim 10, wherein the cleaning process removes the second hardmask layer from over the second region.

13. The method of claim 12 further comprising, forming a semiconductor layer on the cleaned first region surface.

14. The method of claim 13, wherein forming the semiconductor layer comprises, depositing the semiconductor layer directly on the cleaned first region surface by an epitaxial deposition process.

15. The method of claim 14 further comprising, removing any remaining portions of the bilayer hardmask from over the second region.

16. A method of forming a semiconductor structure, the method comprising:
seating a substrate comprising a NMOS region and a PMOS region into a reaction chamber;
depositing a bilayer hardmask over the NMOS region and over the PMOS region, wherein depositing the bilayer hardmask comprises;
depositing a first hardmask layer over both the NMOS region and the PMOS region; and
depositing a second hardmask layer over the first hardmask layer;
selectively removing the bilayer hardmask over the NMOS region to expose a surface of the NMOS region;
performing a cleaning process on the exposed surface of the NMOS region thereby forming a clean NMOS surface;
depositing a semiconductor layer on the clean NMOS surface; and
removing a remaining portion of the bilayer hardmask disposed over the PMOS region.

17. The method of claim 16, wherein the bilayer hardmask is deposited by a cyclical deposition process.

18. The method of claim 16 or 17, wherein the semiconductor layer is deposited by an epitaxial deposition process.

19. The method according to any one of claims 16-18, wherein selectively removing the bilayer hardmask over the NMOS region further comprises, forming a patterned resist layer over the PMOS region and contacting an exposed region of the bilayer hardmask with a wet etchant selected from the group consisting of hydrofluoric acid, sulfuric acid, and phosphoric acid.

20. The method according to any one of claims 16-19, wherein the cleaning process removes the second hardmask layer over the PMOS region whilst maintaining at least a portion of the first hardmask layer over the PMOS region.
